# EUROPEAN PATENT SPECIFICATION

(11) **EP 1 523 712 B1**
(45) Date of publication and mention of the grant of the patent: **27.05.2009**
(21) Application number: 03765490.2
(22) Date of filing: 03.07.2003
(51) Int. Cl.: G06F 12/06

(54) **A SYSTEM, APPARATUS, AND METHOD FOR A FLEXIBLE DRAM ARCHITECTURE**
SYSTEM, VERFAHREN UND ANORDNUNG EINER FLEXIBLEN DRAM ARCHITEKTUR
SYSTEME, APPAREIL ET PROCEDE POUR UNE ARCHITECTURE DRAM FLEXIBLE

(30) Priority: 19.07.2002 US 199578
(43) Date of publication of application: 20.04.2005
(73) Proprietor: Intel Corporation, Santa Clara, CA 95052 (US)
(72) Inventor: DODD, James, Shingle Springs, CA 95682 (US); JOHNSON, Brian, Folsom, CA 95630 (US)
(74) Representative: Goddar, Heinz J.
(86) International application number: PCT/US2003/021133
(87) International publication number: WO 2004/010435

(56) References cited:
- EP-A- 0 640 980
- US-A- 5 278 801
- US-A- 5 390 308

## Description

### BACKGROUND OF THE CLAIMED SUBJECT MATTER

### Field of the Claimed subject matter

The claimed subject matter relates to dynamic random access memory architectures.

### Description of the Related Art

A Dynamic Random Access Memory, DRAM, is a typical memory to store information. DRAMs contain a memory cell array having a plurality of individual memory cells; each memory cell is coupled to one of a plurality of sense amplifiers, bit lines, and word lines. The memory cell array is arranged as a matrix of rows and columns, and the matrix is further subdivided into a number of banks

A memory controller requests data information from the DRAM by forwarding three addresses, one each for a bank, row, and column. The memory controller is dependent on the individual DRAM architecture because the memory controller needs to explicitly indicate which bank is accessed and which row and page is active in each bank. Thus, future DRAM architectures require extensive changes in the memory controller design.
US patent 5,390,308 discloses a method and apparatus for remapping of row addresses of memory requests to random access memories. As the memory access is faster if the requested row is already located in a latch and memory accesses frequently experience spatial and temporal locality, address remapping is performed to distribute neighboring accesses among the banks of memory. By distributing access among the banks of memory, the probability that the requested row is located in a latch is increased and the contention for a single latch is decreased. The address remapping is adaptable to different memory sizes and configurations by modification of the address select register. The device type bits contained in a device type register located in each memory type are used to provide information regarding the memory configuration of the device.
European patent application EP 0 640 980 A2 discloses a semiconductor memory having a plurality of banks. The semiconductor memory is used for different bank configurations and is capable of serving as a memory having a smaller number of banks.
US 4,926,314 discloses a method and apparatus for determining an available memory size in a computer system employing memory devices having discrete capacity (i.e. 256 Kbit, 1 Mbit, etc.) such as random access memory. A bit value is assigned which corresponds to the available memory size of the first memory bank. This bit value is stored in a register coupled to control logic which controls the operation of the multiplexer and generates row address and column address signals to access the memory. Memory banks are selected by the control logic based upon the logical state of predetermined address bits outputted by the CPU which are identified by the bit value.

### BRIEF DESCRIPTION OF THE DRAWINGS

Subject matter is particularly pointed out and distinctly claimed in the concluding portion of the specification. The claimed subject matter, however, both as to organization and method of operation, together with objects, features, and advantages thereof, may best be understood by reference to the following detailed description when read with the accompanying drawings in which:
- Fig. 1: is a schematic diagram in accordance with one embodiment.
- Fig. 2: is a flowchart of a method in accordance with one embodiment.
- Fig. 3: is a system in accordance with one embodiment.

### DETAILED DESCRIPTION

In the following description, for purposes of explanation, numerous details are set forth in order to provide a thorough understanding of the claimed subject matter. However, it will be apparent to one skilled in the art that these specific details are not required in order to practice the claimed subject matter.

An area of current technological development relates to optimizing DRAM architectures to allow for compatibility with a variety of memory controller designs. As previously described, prior art memory controller and DRAM architectures utilize three address fields. However, the prior art DRAM architectures preclude migration for different bank and row configurations because of incompatibility with the existing memory controller designs. In contrast, a memory controller that is independent from the DRAM architecture results in optimizing DRAM and memory controller designs for a specific application and facilitating a transition to new and future DRAM architectures while supporting old and existing memory controller architectures. Therefore, a single DRAM component type would be compatible with a variety of memory controller architectures.

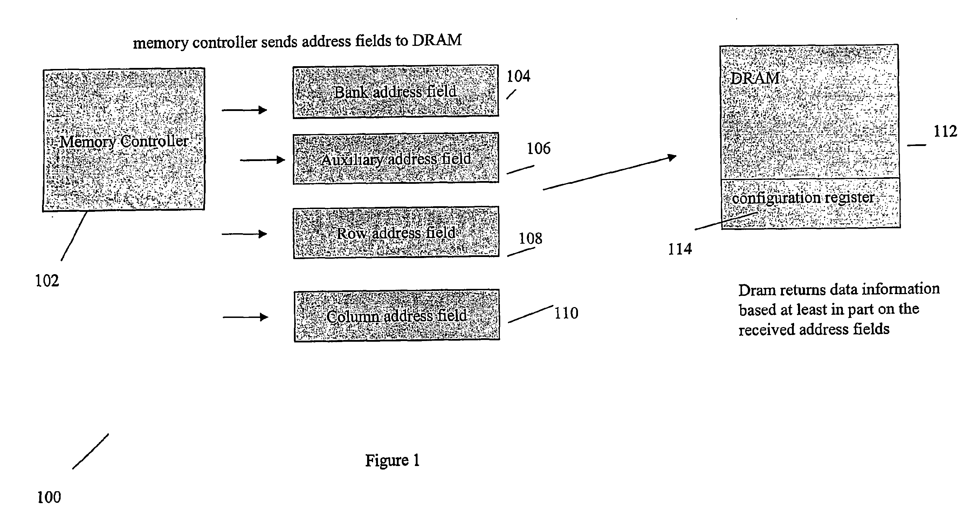

In one aspect, the claimed subject matter establishes a DRAM architecture to allow the number of supported banks to be transparent to the memory controller. In another aspect, the claimed subject matter increases the flexibility of DRAM and memory controller architectures by including an auxiliary address field that is based at least in part on the functional capability of the DRAM and memory controller. In yet another aspect, the claimed subject matter facilitates an overlap mapping of bank and row addresses. Fig. 1 is a schematic diagram 100 in accordance with one embodiment. The schematic 100 includes, but is not limited to, a memory controller 102 and a DRAM 112. The memory controller 102 requests data information from the DRAM by forwarding four address fields: a bank address field 104, an auxiliary address field 106, a row address field 108, and a column address field 110.

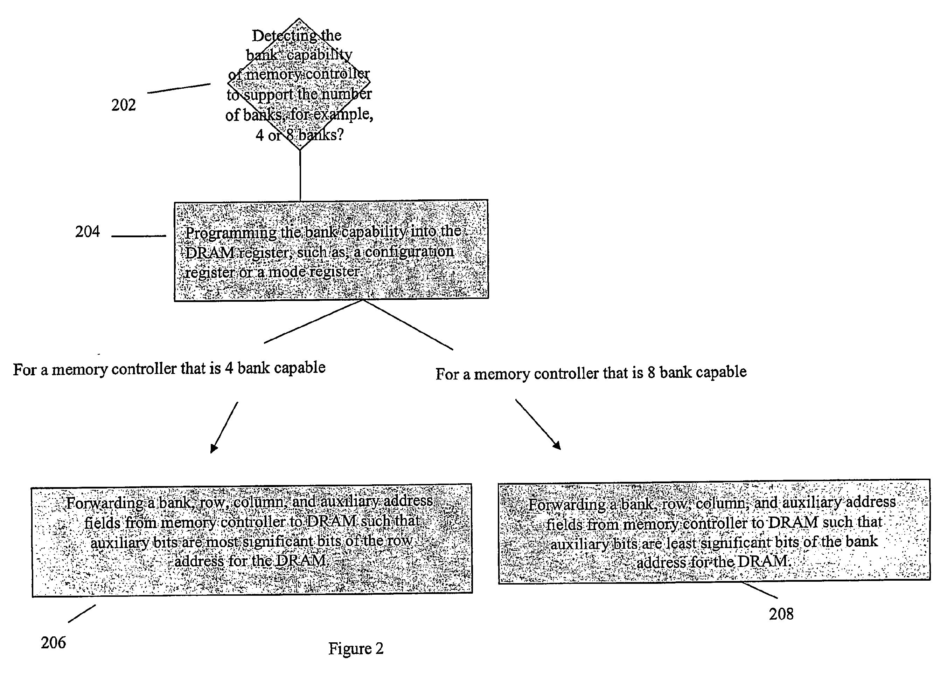

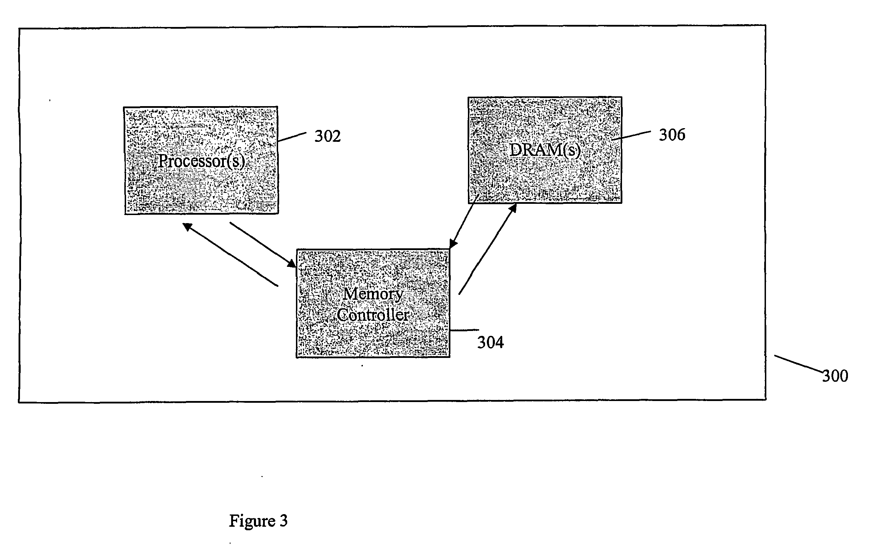

In one embodiment, the DRAM supports the conventional address scheme, however, the DRAM further includes supporting the use of the auxiliary address field. Likewise, the utilization of the auxiliary address field is based at least in part on the functional capability of the DRAM and memory controller. For example, the auxiliary address field can be used as either bank or row address to support different DRAM bank configurations, which is illustrated in the next few paragraphs and in connection with Figures 2 and 3.

For example, a DRAM with a storage capability of 256 million bits (Mb) would have an address mapping of two bits for the bank address field, one bit for the auxiliary address field, twelve for the row address field, and ten bits for the column address field. However, if a particular application requires a different configuration of the 256Mb to have a different number of banks or rows, the prior art memory controller could not support the different configuration. In contrast, the schematic 100 allows for flexibility by interpreting the auxiliary address field by adjusting to the different configuration. For example, the bank address is the combination of the auxiliary address field bits and the bank address field bits for supporting a configuration with an increase in banks. In contrast, the row address is the combination of the auxiliary address field bits and the row address field bits for supporting a configuration with an increase in rows. In one embodiment, the auxiliary address field is the least significant bits of the bank address. In another embodiment, the auxiliary address field is the most significant bits of the row address. In one embodiment, the DRAM is programmed via a configuration register 114 to indicate the memory controller's use of the auxiliary address field bits. There are no special latching or sampling requirements for the auxiliary address field since it is latched at the same time as the row and column address field, which is well known in the art. In one embodiment, the memory controller interprets the auxiliary address field bits as the least significant bits of the bank address for a bank activate.

However, the claimed subject matter is not limited to the auxiliary address field representing the least significant bits of the bank address or the most significant bits of the row address. For example, the auxiliary address field bits could represent the least significant bits of the row address or the most significant bits of the bank address. Another example, the auxiliary address field bits could represent a specified range within a bank or row address, such as, bits 3:4 for two auxiliary address bits.

Fig. 2 is a flowchart of a method in accordance with one embodiment. The flowchart comprises a plurality of diamonds and blocks 202, 204, 206, and 208. In one embodiment, the method depicts establishing a transparency from a memory controller's perspective as to the number of supported banks within a DRAM.

Detecting the bank capability of memory controller to support the number of banks, as illustrated by the diamond 202. For example, the number of banks detected is either four or eight banks. Programming the bank capability into the DRAM register, as illustrated by the block 204. For example, the DRAM register is a configuration register or a mode register. If the memory controller has a four-bank capability, then forwarding a plurality of bank, row, column, and auxiliary address fields from memory controller to DRAM such that auxiliary bits are most significant bits of the row address for the DRAM, as illustrated by block 206. However, if the memory controller has a eight bank capability, then forwarding a plurality of bank, row, column, and auxiliary address fields from memory controller to DRAM such that auxiliary bits are the least significant bits of the bank address for the DRAM, as illustrated by block 208.

However, the claimed subject matter is not limited to detecting four or eight bank capability. For example, the flowchart supports various permutations of bank capability to include two, sixteen, etc...

In one embodiment, the blocks 206 and 208 will preclude the memory controller from forwarding the auxiliary address field bits for conditions, such as, a precharge or a read and write command.

Figure 3 depicts a system in accordance with one embodiment. The system 300 comprises a processor 302, a memory controller 304, and a DRAM 306. In one embodiment, the system 300 is a single processor system. In an alternative embodiment, the system comprises multiple processors 302. The processor decodes and executes instructions and requests data and directory information from the DRAM 306 via the memory controller 304.

In one embodiment, the system is a computer. In another embodiment, the system is a computing system, such as, a personal digital assistant (PDA), communication device, or Internet tablet. In one embodiment, the DRAM is a synchronous dynamic random access memory (DRAM).

In one embodiment, the memory controller is an integrated device. In an alternative embodiment, a chipset includes the memory controller. The DRAM 306 supports the address protocol depicted in connection with Figure 1 and the flowchart for establishing a transparency from a memory controller's perspective as to the number of supported banks depicted in connection with Figure 2.

Although the claimed subject matter has been described with reference to specific embodiments, this description is not meant to be construed in a limiting sense. Various modifications of the disclosed embodiment, as well as alternative embodiments of the claimed subject matter, will become apparent to persons skilled in the art upon reference to the description of the claimed subject matter. It is contemplated, therefore, that such modifications can be made without departing from the scope of the claimed subject matter as defined in the appended claims.

## Claims

1. A method for addressing a dynamic random access memory (DRAM) (112) with a plurality of rows, columns, and banks comprising:
programming the DRAM (112) via a mode register (114) to indicate an interpretation of auxiliary address field bits by a memory controller (102) such that, an auxiliary address field is to be combined with a bank address field (104) to form a bank address for the DRAM or such that the auxiliary address field (106) is to be combined with a row address field (108) to form a row address for the DRAM (112) when increasing the number of rows supported by the DRAM
forwarding at least one address field (104) to the DRAM (112) wherein the auxiliary address field bits are between the row address field (108) and the bank address field (104) such that the auxiliary address field bits can be interpreted as least significant bits of the row address or as most significant bits of the bank address to allow for an overlap mapping of a bank address (104) and a row address (108) based at least in part on a functional capability of the DRAM (112); and
addressing the DRAM (112) based at least in part on the auxiliary address field (106).

2. The method of claim 1 wherein a memory controller forwards the auxiliary address field (106), a bank address field (104), a row address field (108), and a column address field (110).

3. The method of claim 1 wherein the number of banks supported by the DRAM is transparent to the memory controller (102).

4. An apparatus to address a dynamic random access memory (DRAM) with a plurality of rows, columns, and banks comprising:
a memory controller (102) to forward a plurality of address fields (104, 108, 110), with an auxiliary address field (106), to allow for an overlap mapping of a bank address and a row address based at least in part on a functional capability of the DRAM (112); and
**characterized in that**
the DRAM (112) includes a mode register (114) that is programmed to indicate a memory controller's interpretation of the auxiliary address field (106) such that, an auxiliary address field is to be combined with a bank address field (104) to form a bank address for the DRAM or such that the auxiliary address field (106) is to be combined with a row address field (108) to form a row address for the DRAM (112) when increasing the number of rows supported by the DRAM wherein the auxiliary address field bits are between the row address field (108) and the bank address field (104) such that the auxiliary address field bits can be interpreted as least significant bits of the row address or as most significant bits of the bank address.

5. The apparatus of claim 4 wherein the memory controller forwards the plurality of address fields including at least the auxiliary address field (106), a bank address field (104), a row address field (108), and a column address field (110).

6. The apparatus of claim 4 wherein the number of banks supported by the DRAM is transparent to the memory controller (114).

7. The apparatus of one of claims 4 to 6, comprising:
at least one processor, coupled to the memory controller (114), to issue requests for data information from the at least one dynamic random access memory (DRAM).

8. The apparatus of one of claims 4 to 7 wherein the DRAM (112) is a synchronous dynamic random access memory (SDRAM).

## Patentansprüche

1. Verfahren zum Adressieren eines Direktzugriffsspeichers (DRAM) (112) mit einer Vielzahl von Zeilen, Spalten und Bänken, das folgende Schritte aufweist:
Programmieren des DRAM (112) durch ein Modusregister (114), um eine Interpretation von Zusatzadressenfeldbits durch einen Speicher-Controller (102) anzuzeigen, so dass ein Zusatzadressenfeld mit einem Bankadressenfeld (104) zu kombinieren ist, um eine Bankadresse des DRAM zu bilden, oder so dass das Zusatzadressenfeld (106) mit einem Zeilenadressenfeld (108) zu kombinieren ist, um eine Zeilenadresse des DRAM (112) zu bilden, wenn die Anzahl der Zeilen, die von dem DRAM unterstützt werden, erhöht wird;
Weiterleiten von mindestens einem Adressenfeld (104) an den DRAM (112), wobei die Zusatzadressenfeldbits zwischen dem Zeilenadressenfeld (108) und dem Bankadressenfeld (104) sind, so dass die Zusatzadressenfeldbits als niedrigstwertige Bits der Zeilenadresse oder als höchstwertige Bits der Bankadresse interpretiert werden können, um eine Überlappungsabbildung einer Bankadresse (104) und einer Zeilenadresse (108) zu ermöglichen, die zumindest teilweise auf einer Funktionsfähigkeit des DRAM (112) basiert; und
Adressieren des DRAM (112) zumindest teilweise basierend auf dem Zusatzadressenfeld (106).

2. Verfahren nach Anspruch 1, wobei ein Speicher-Controller das Zusatzadressenfeld (106), ein Bankadressenfeld (104), ein Zeilenadressenfeld (108) und ein Spaltenadressenfeld (110) weiterleitet.

3. Verfahren nach Anspruch 1, wobei die Anzahl der Bänke, die von dem DRAM unterstützt werden, für den Speicher-Controller (102) erkennbar ist.

4. Vorrichtung zum Adressieren eines Direktzugriffsspeichers (DRAM) mit einer Vielzahl von Zeilen, Spalten und Bänken, die folgendes aufweist:
einen Speicher-Controller (102), um eine Vielzahl von Adressenfeldern (104, 108, 110) weiterzuleiten, mit einem Zusatzadressenfeld (106), um eine Überlappungsabbildung einer Bankadresse und einer Zeilenadresse zu ermöglichen, die zumindest teilweise auf einer Funktionsfähigkeit des DRAM (112) basiert; und **dadurch gekennzeichnet ist, dass**
der DRAM (112) einen Modusregister (114) umfasst, der programmiert ist, um eine Interpretation des Zusatzadressenfelds (106) durch einen Speicher-Controller anzuzeigen, so dass ein Zusatzadressenfeld mit einem Bankadressenfeld (104) zu kombinieren ist, um eine Bankadresse des DRAM zu bilden, oder so dass das Zusatzadressenfeld (106) mit einem Zeilenadressenfeld (108) zu kombinieren ist, um eine Zeilenadresse des DRAM (112) zu bilden, wenn die Anzahl der Zeilen, die von dem DRAM unterstützt werden, erhöht wird, wobei die Zusatzadressenfeldbits zwischen dem Zeilenadressenfeld (108) und dem Bankadressenfeld (104) sind, so dass die Zusatzadressenfeldbits als niedrigstwertige Bits der Zeilenadresse oder als höchstwertige Bits der Bankadresse interpretiert werden können.

5. Vorrichtung nach Anspruch 4, wobei der Speicher-Controller die Vielzahl der Adressenfelder weiterleitet, die mindestens das Zusatzadressenfeld (106), ein Bankadressenfeld (104), ein Zeilenadressenfeld (108) und ein Spaltenadressenfeld (110) umfassen.

6. Vorrichtung nach Anspruch 4, wobei die Anzahl der Bänke, die von dem DRAM unterstützt werden, für den Speicher-Controller (114) erkennbar ist.

7. Vorrichtung nach einem der Ansprüche 4 bis 6, die folgendes aufweist:
mindestens einen Prozessor, der an den Speicher-Controller (114) gekoppelt ist, um Anfragen für Dateninformationen von dem mindestens einen Direktzugriffsspeicher (DRAM) auszugeben.

8. Vorrichtung nach einem der Ansprüche 4 bis 7, wobei der DRAM (112) ein Synchroner Direktzugriffsspeicher (SDRAM) ist.

## Revendications

1. Procédé pour adresser une mémoire vive dynamique (DRAM) (112) avec une pluralité de lignes, de colonnes et de banques, comprenant les étapes consistant à :
programmer la DRAM (112) via un registre de mode (114) pour indiquer une interprétation de bits de champ d'adresse auxiliaire par un contrôleur de mémoire (102), de sorte qu'un champ d'adresse auxiliaire doit être combiné avec un champ d'adresse de banque (104) afin de former une adresse de banque pour la DRAM, ou de sorte que le champ d'adresse auxiliaire (106) doit être combiné avec un champ d'adresse de ligne (108) afin de former une adresse de ligne pour la DRAM (112) lors d'une augmentation du nombre de lignes supportées par la DRAM.
transmettre au moins un champ d'adresse (104) à la DRAM (112), les bits de champ d'adresse auxiliaire se trouvant entre le champ d'adresse de ligne (108) et le champ d'adresse de banque (104), de sorte que les bits de champ d'adresse auxiliaire peuvent être interprétés comme des bits les moins importants de l'adresse de ligne ou les bits les plus importants de l'adresse de banque afin de permettre un mappage de chevauchement d'une adresse de banque (104) et d'une adresse de ligne (108) sur la base au moins en partie d'une capacité fonctionnelle de la DRAM (112), et
adresser la DRAM (112) sur la base au moins en partie du champ d'adresse auxiliaire (106).

2. Procédé selon la revendication 1, dans lequel un contrôleur de mémoire transmet le champ d'adresse auxiliaire (106), un champ d'adresse de banque (104), un champ d'adresse de ligne (108), et un champ d'adresse de colonne (110).

3. Procédé selon la revendication 1, dans lequel le nombre de banques supportées par la DRAM est transparent pour le contrôleur de mémoire (102).

4. Appareil pour adresser une mémoire vive dynamique (DRAM) avec une pluralité de lignes, de colonnes, et de banques, comprenant :
un contrôleur de mémoire (102) pour transmettre une pluralité de champs d'adresse (104, 108, 110), avec un champ d'adresse auxiliaire (106), afin de permettre un mappage de chevauchement d'une adresse de banque et d'une adresse de ligne sur la base au moins en partie d'une capacité fonctionnelle de la DRAM (112), et **caractérisé en ce que**
la DRAM (112) comprend un registre de mode (114) qui est programmé pour indiquer une interprétation du contrôleur de mémoire du champ d'adresse auxiliaire (106), de sorte qu'un champ d'adresse auxiliaire doit être combiné avec un champ d'adresse de banque (104) pour former une adresse de banque pour la DRAM, ou de sorte que le champ d'adresse auxiliaire (106) doit être combiné avec un champ d'adresse de ligne (108) afin de former une adresse de ligne pour la DRAM (112) lors d'une augmentation du nombre de lignes supportées par la DRAM, les bits de champ d'adresse auxiliaire se trouvant entre le champ d'adresse de ligne (108) et le champ adresse de banque (104), de sorte que les bits de champ d'adresse auxiliaire peuvent être interprétés comme les bits les moins importants de l'adresse de ligne ou les bits les plus importants de l'adresse de banque.

5. Appareil selon la revendication 4, dans lequel le contrôleur de mémoire transmet la pluralité de champs d'adresse comprenant au moins le champ d'adresse auxiliaire (106), un champ d'adresse de banque (104), un champ d'adresse de ligne (108), et un champ d'adresse de colonne (110).

6. Appareil selon la revendication 4, dans lequel le nombre de banques supportées par la DRAM est transparent pour le contrôleur de mémoire (114).

7. Appareil selon l'une quelconque des revendications 4 à 6, comprenant :
au moins un processeur, couplé au contrôleur de mémoire (114), pour délivrer des demandes d'informations de données à partir de la au moins une mémoire vive dynamique (DRAM).

8. Appareil selon l'une quelconque des revendications 4 à 7, dans lequel la DRAM (112) est une mémoire vive dynamique synchrone (SDRAM).
